# EUROPEAN PATENT SPECIFICATION

(11) **EP 2 660 885 B1**
(45) Date of publication and mention of the grant of the patent: **18.08.2021**
(21) Application number: 11852820.7
(22) Date of filing: 07.12.2011
(51) Int. Cl.: H01L 33/50, G02F 1/13357

(54) **OPTICAL DEVICE, LIGHT EMITTING DIODE PACKAGE USING THE SAME, AND BACKLIGHT APPARATUS**
OPTISCHE VORRICHTUNG, LEUCHTDIODENPAKET DAMIT UND RÜCKBELEUCHTUNGSVORRICHTUNG
DISPOSITIF OPTIQUE, BOÎTIER DE DIODE ÉLECTROLUMINESCENTE L'UTILISANT ET APPAREIL DE RÉTROÉCLAIRAGE

(30) Priority: 28.12.2010 KR 20100136883
(43) Date of publication of application: 06.11.2013
(73) Proprietor: LG Electronics Inc., Seoul 07336 (KR)
(72) Inventor: YEE, Youngjoo, Seoul 150-721 (KR); SONG, Kichang, Seoul 150-721 (KR)
(74) Representative: Ter Meer Steinmeister & Partner
(86) International application number: PCT/KR2011/009403
(87) International publication number: WO 2012/091312

(56) References cited:
- WO-A1-2009/078426
- WO-A1-2010/077226
- JP-A- 2006 083 219
- KR-A- 20080 026 529
- KR-A- 20100 029 519
- KR-A- 20100 129 030
- KR-A- 20100 129 030
- US-A1- 2004 150 991
- US-A1- 2007 004 065
- US-A1- 2010 103 648
- None

## Description

### Technical Field

The teachings in accordance with exemplary embodiments of this invention relate generally to an optical device, and more particularly to an optical device for use in a LED (Light Emitting Diode) package.

### Background Art

WO 2010/077226 A1 relates to a method for hermetically sealing luminescent nanocrystals, as well as compositions and containers comprising hermetically sealed luminescent nanocrystals. By hermetically sealing the luminescent nanocrystals, enhanced lifetime and luminescence can be achieved.

US 2007/0004065 A1 describes a phosphor tape article including a phosphor layer having a phosphor and a polymeric binder material, a pressure sensitive adhesive layer disposed adjacent the phosphor layer such that light transmitted through the pressure sensitive adhesive layer is received by the phosphor layer, and a release liner disposed on the pressure sensitive adhesive layer. The pressure sensitive adhesive layer is disposed between the release liner and the phosphor layer. The phosphor is suitable for excitation by UV or blue LED light, and the phosphor emission has a characteristic decay rate of less than 1 second.

LEDs (Light emitting diodes) are well-known semiconductor devices that emit light when electrically biased in a forward direction. The light emission is a form of electroluminescence. A wide variety of light emitting diodes are used in increasingly diverse fields for an ever-expanding range of purposes.

The LEDs may have lower electric power consumption and a longer lifetime as compared with conventional light bulbs or fluorescent lamps, so that their applications have been expanded into general illumination while substituting for conventional incandescent bulbs and fluorescent lamps. Semiconductor based white Light Emitting Diodes (LEDs) are increasingly becoming efficient with proven long life and reliability. Hereinafter, R, G, and B respectively are abbreviations of red, green, and blue and will respectively denote red, green, and blue throughout without separate indication.

Recently, LED packages capable of emitting white light have been developed. Particularly, various types of LED packages, which emit mixed-color light, e.g., white light, have been introduced into the marketplace. However, typically, a white LED package, based on semiconductor technology, is classified into two families. The first one belongs to the three-color mixed white, and the second one belongs to the phosphor converted white.

Three color mixed white is obtained by employing red emitting LED, blue emitting LED and green emitting LED and mixing the emitted colors in the ratio of green: red: blue = 64:28:8. To have this ratio from LED's emission, LEDs have to be properly powered. The LEDs need to be arranged physically in such a way that the rays emitted by the three color LEDs are mixed. The resulting mix gives the appearance of white light. The white light contains a spectrum emitted by three red (R), blue (B), and green (G) LEDs. The white light can be used for consumer lighting as well as for backlighting LCDs. However, the method of mixing three-color is disadvantageous in that there is a limitation of miniaturization of entire package, randomicity of color mixing occurs due to each LED characteristic, and difference of degradation aspects occurs, thereby causing increased irregularity of white color.

In case of the phosphor converted white, where the LED package is coated by conversion material comprising one or more phosphors, spectrums corresponding to red and green are not vivid, such that, if used as a light source for a liquid crystal display, color expression performance is lower than that of application of each red, green and blue LED, and if used as a general lighting application, CRI (Color Rendering Index), a relative measurement of how the color rendition of an illumination system compares to that of a reference illuminator (light source such as natural light),is unsatisfactory, whereby it is difficult to adequately cater to a consumer need regarding color temperature in illumination.

### Technical problem

The present general inventive concept is directed to solving the aforementioned problems or disadvantages by providing a transparent thin film-shaped optical device configured to prevent degradation of semiconductor nano particles, which are quantum dot particles that emit light by converting wavelength of excitation light, and an LED (Light Emitting Diode) package using the optical device.

Technical problems to be solved by the present invention are not restricted to the above-mentioned, and any other technical problems not mentioned so far will be clearly appreciated from the following description by skilled in the art. Additional aspects and advantages of the present general inventive concept will be set forth in part in the description which follows and, in part, will be obvious from the description, or may be learned by practice of the general inventive concept.

### Technical Solution

According to a general aspect and an exemplary embodiment of the present invention, there is provided an optical device, comprising: a substrate; a first transparent thin film layer formed at one surface of the substrate; a quantum dot layer (quantum well) formed at an upper surface of the first transparent thin film layer and consisting of quantum dot particles; a protective layer formed on both the upper surface and the bottom surface of the quantum dot layer and formed with metallic oxide nano particles; a barrier member formed on the upper surface of the first transparent thin film layer for establishing an area formed with the quantum dot layer and the protective layer; and a second transparent thin film layer formed at an extreme upper layer of the optical device, wherein the second transparent thin film layer is formed in such a way that the quantum dot layer and the protective layer are airtightly sealed.

Preferably, but not necessarily, the quantum dot layer is diffusively mixed with the quantum dot particles at a predetermined ratio, each quantum dot particle having a different band gap.

Preferably, but not necessarily, the quantum dot layer is diffusively mixed with the quantum dot particles at a predetermined ratio, each quantum dot particle having a different band gap, wherein the quantum dot particles include a first quantum dot particle wavelength-converting blue light to red light, and a second quantum dot particle wavelength-converting blue light to green light.

Preferably, but not necessarily, the metallic oxide nano particles include at least one of ZnO, TiO₂, Al₂O₃, Ta₂O₅, MgO, NiO, Cr₂O₃, WO₃ and VOₓ.

Preferably, but not necessarily, the barrier member further includes a plurality of columns or grid-shaped lugs, each formed at a predetermined gap by passing through the quantum dot layer and the protective layer.

According to another general aspect and an exemplary embodiment of the present invention, there is provided a light emitting diode (LED) package, comprising: the optical device; and an LED chip, comprising: a housing including: an LED; a bottom surface part mounted with the LED; a lateral wall part protruded to an upper direction from the bottom surface part to encompass the LED; and an optical emission part formed on an opened upper surface of the lateral wall part, wherein the optical device is bonded to the optical emission part and includes quantum dot particles emitting light by wavelength converting a part of the light emitted by the LED.

Preferably, but not necessarily, the housing further comprises a reflective surface formed at an inner surface of the lateral wall part.

Preferably, but not necessarily, an inner space encompassed by the lateral wall part is filled with a transparent refractivity matching material for enhancing an optical extraction efficiency of the LED.

Preferably, but not necessarily, the LED package is further comprising a luminosity adjusting part formed on an upper surface of the optical device.

Preferably, but not necessarily, the luminosity adjusting part is any one of a dome-shaped lens, a fine lens arrangement or a convexly/concavely shaped layer.

According to still another general aspect and an exemplary embodiment of the present invention, there is provided a backlight apparatus applied with the LED package.

### Advantageous Effects

The optical device and LED package using the same, and backlight apparatus thus mentioned according to the present invention have advantageous effects in that both surfaces of the quantum dot layer consisting of quantum dot particles are deposited or coated with a protective layer formed with metallic oxide nano particles, and that the second transparent thin film layer is formed in such a way that the quantum dot layer and the protective layer are airtightly sealed, whereby reliability and durability of the quantum dot particles can be enhanced and degradation in performance caused by moisture, oxygen and ultraviolet can be prevented.

Another advantageous effect is that the optical device according to the present invention is formed by stacking quantum dot layers on a substrate to allow manufacturing a plurality of chip-shaped optical devices from a large scale substrate, whereby manufacturing cost and deviation between each optical device can be reduced.

The LED package has an advantageous effect in that the LED package is formed by integrating an optical device including quantum dot particles emitting light by wavelength-converting light emitted from LEDs on LED chips, whereby the LED package can be easily miniaturized, which is conducive to application of mass production because of using a method of assembling chip-shaped parts, thereby reducing the manufacturing cost.

The LED package has another advantageous effect in that white light formed with three colors each having a narrow full length half-maximum is provided to enable a color display of higher purity, a good CRI (Color Rendering Index) and an easy adjustment of color temperature.

### BRIEF DESCRIPTION OF THE DRAWINGS

FIGS. 1a and 1b are schematic perspective views illustrating configuration of an optical device according to an exemplary embodiment of the present invention.
FIGS. 2a and 2b are schematic cross-sectional views illustrating configuration of an optical device according to an exemplary embodiment of the present invention.
FIG.3 is a schematic perspective view illustrating an LED package according to the present invention.
FIG.4 is a schematic view illustrating a light emitting spectrum of an LED package according to an exemplary embodiment of the present invention.
FIGS.5a and 5b are perspective and cross-sectional views illustrating an LED package according to another exemplary embodiment of the present invention.
FIGS.6a and 6b are perspective and cross-sectional views illustrating an LED package according to still another exemplary embodiment of the present invention.
FIGS.7a and 7b are perspective and cross-sectional views illustrating an LED package according to still another exemplary embodiment of the present invention.
FIG.8 is a perspective view illustrating an LED package according to still another exemplary embodiment of the present invention.

### Best Mode

The following description is not intended to limit the invention to the form disclosed herein. Consequently, variations and modifications commensurate with the following teachings, and skill and knowledge of the relevant art are within the scope of the present invention. The embodiments described herein are further intended to explain modes known of practicing the invention and to enable others skilled in the art to utilize the invention in such, or other embodiments and with various modifications required by the particular application(s) or use(s) of the present invention.

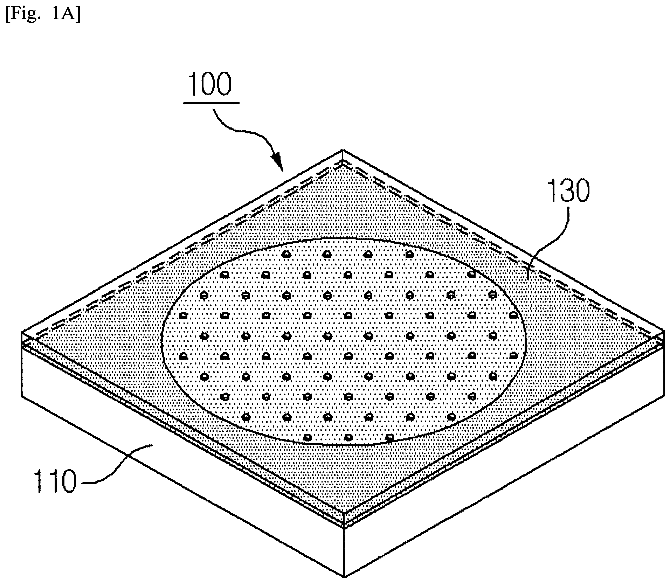

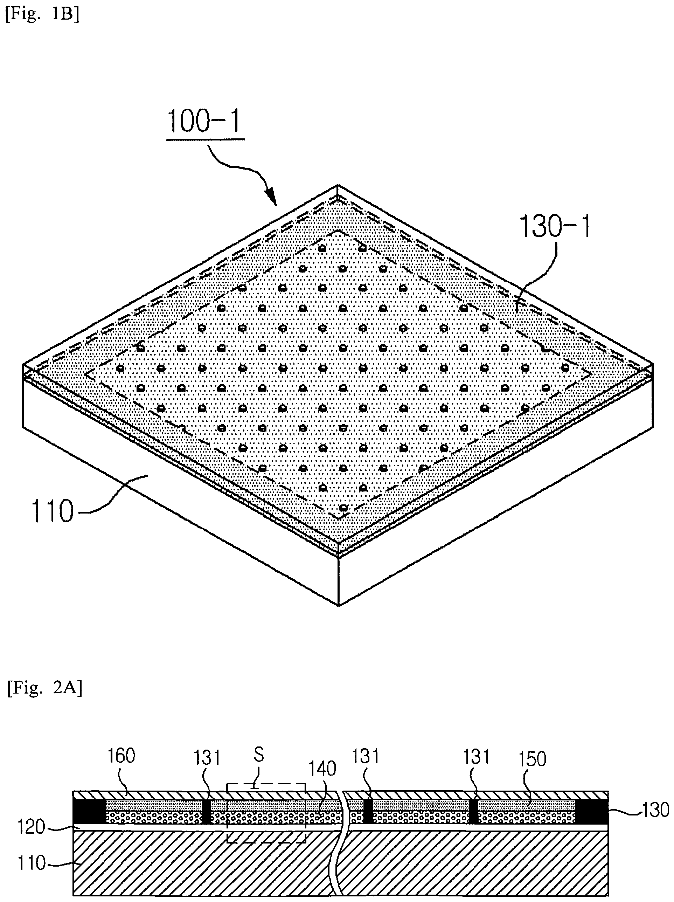

The disclosed embodiments and advantages thereof are best understood by referring to FIGS. 1-8 of the drawings, like numerals being used for like and corresponding parts of the various drawings. Other features and advantages of the disclosed embodiments will be or will become apparent to one of ordinary skill in the art upon examination of the following figures and detailed description. It is intended that all such additional features and advantages be included within the scope of the invention. Further, the illustrated figures are only exemplary and not intended to assert or imply any limitation with regard to the environment, architecture, or process in which different embodiments may be implemented. Accordingly, the described aspect is intended to embrace all such alterations, modifications, and variations that fall within the scope of the present invention.

It will be understood that the terms "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof. That is, the terms "including", "includes", "having", "has", "with", or variants thereof are used in the detailed description and/or the claims to denote non-exhaustive inclusion in a manner similar to the term "comprising".

Furthermore, "exemplary" is merely meant to mean an example, rather than the best. It is also to be appreciated that features, layers and/or elements depicted herein are illustrated with particular dimensions and/or orientations relative to one another for purposes of simplicity and ease of understanding, and that the actual dimensions and/or orientations may differ substantially from that illustrated. That is, in the drawings, the size and relative sizes of layers, regions and/or other elements may be exaggerated or reduced for clarity.

Words such as "thus," "then," "next," "therefore", etc. are not intended to limit the order of the processes; these words are simply used to guide the reader through the description of the methods.

It will be understood that when an element is referred to as being "connected" or "coupled" to another element, it can be directly connected or coupled to the other elements or intervening elements may be present. In contrast, when an element is referred to as being "directly connected" or "directly coupled" to another element, there are no intervening elements present.

It will be understood that, although the terms first, second, etc. may be used herein to describe various elements, these elements should not be limited by these terms. These terms are only used to distinguish one element from another. For example, a first region/layer could be termed a second region/layer, and, similarly, a second region/layer could be termed a first region/layer without departing from the teachings of the disclosure.

The terminology used herein is for the purpose of describing particular embodiments only and is not intended to be limiting of the general inventive concept. As used herein, the singular forms "a", "an" and "the" are intended to include the plural forms as well, unless the context clearly indicates otherwise. In addition, the terms "-er", "-or", "part" and "module" described in the specification mean units for processing at least one function and operation and can be implemented by hardware components or software components, and combinations thereof.

Now, the optical device and light emitting diode package using the same, and a backlight apparatus according to exemplary embodiments of the present invention will be described in detail with reference to the accompanying drawings. Like numbers refer to like elements throughout and explanations that duplicate one another will be omitted.

FIGS. 1a and 1b are schematic perspective views illustrating configuration of an optical device according to an exemplary embodiment of the present invention.

Referring to FIGS. 1a and 1b, each of optical devices (100, 100-1) according to the present invention has a transparent thin film chip shape formed with a quantum dot layer.

A quantum dot, a material having photo-luminescent properties, is a semiconductor nanocrystal having a diameter of approximately 10 nm or less and produces a quantum confinement effect. That is, a quantum dot is a (nano) particle or portion of a larger material that exhibits quantum confinement in three dimensions. The quantum dot may emit light stronger than that emitted by a general phosphor within a narrow wavelength band. Light emission by the quantum dot may be implemented by the transfer of excited electrons from a conduction band to a valence band. Even in the case of a quantum dot of the same material, the quantum dot may emit light having different wavelengths according to a particle size thereof. As the size of the quantum dot is reduced, the quantum dot may emit short-wavelength light. Accordingly, light having a desired wavelength band may be obtained by adjusting the particle size of the quantum dot.

That is, light emission in the quantum dot may be implemented by the transfer of excited electrons from a conduction band to a valence band. Even in the case of a quantum dot of the same material, the quantum dot may emit light having different wavelengths according to a particle size thereof. As the size of the quantum dot is reduced, the quantum dot may emit short-wavelength light. Light having a desired wavelength band may be obtained by adjusting the size of the quantum dot. Here, the size of the quantum dot may be adjusted by appropriately changing the growth conditions of nanocrystals.

The quantum dot particle may emit light by converting excited high energy light to longer wavelength light corresponding to a band gap determined by particle size thereof. That is, red, green, and blue emission could be obtained by simply varying the quantum dot particle size. For example, green light is emitted, in a case blue light is emitted to a quantum dot particle whose energy value of band gap corresponds to green light by adjustment of particle size, and red light is emitted, in a case blue light is emitted to a quantum dot particle whose energy value of band gap corresponds to red light by adjustment of particle size.

In a case quantum dot particles are so arranged as to have uniform size, the quantum dot characteristically emit light near to natural light very narrow FWHM (Full Width Half Maximum)in a desired wavelength region, where the FWHM refers to the full-width half-maximum of blue, green and red light.

Although the optical devices (100, 100-1) according to the present invention are illustrated with a round shape (FIG. 1a) and a square shape (FIG.1b) as a shape of region where optical emission phenomenon is expressed by the quantum dot, the invention is not limited thereto. For example, the region may be formed in various shapes adequate to fields applying light emission phenomenon of optical devices including the quantum dot particles.

The optical devices (100, 100-1) according to the present invention include a substrate (110) and barrier members (130, 130-1).

The substrate (110) may be embodied by glass or optical transparent film. The optical transparent film may include, for example, various transparent plastic materials such as PET (polyethylene terephthalate), PEN (polyethylene naphthalate), PC (polycarbonate), and acryl. However, the present invention is not limited thereto.

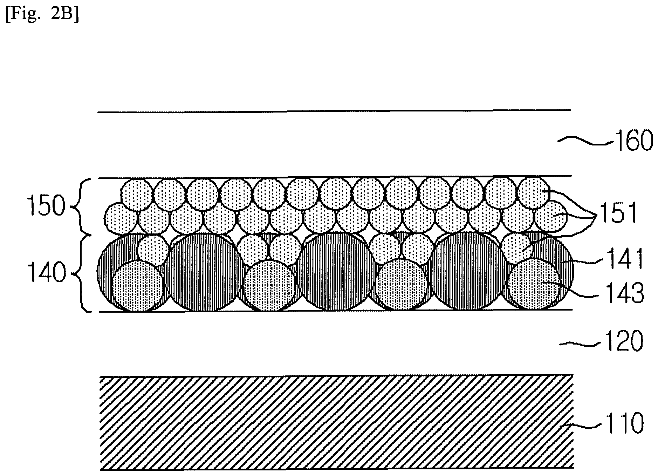

Each of the barrier members (130, 130-1) is so formed as to set a light emission region with quantum dot layers stacked thereon. The optical devices (100, 100-1) according to the present invention are formed by stacking quantum dot layers on the substrate, such that a plurality of chip-shaped optical devices can be manufactured on and divided from the substrate, as in the manufacturing process of silicon IC devices, and the barrier members (130, 130-1) may be used as a divisional reference line of each optical device chip arranged on the substrate. A multi-layered structure stacked in a region set by the barrier members (130, 130-1) will be described in detail with reference to FIGS.2a and 2b.

FIGS. 2a and 2b are schematic cross-sectional views illustrating configuration of an optical device according to an exemplary embodiment of the present invention, where FIG.2b is a view illustrating a detailed structure relative to a partial area (S) of FIG.2 a.

Referring to FIGS. 2a and 2b, the optical device (100) according to the present invention includes a substrate (110), a first transparent thin film layer (120), a barrier member (130), a quantum dot layer (140), a protective layer (150) and a second transparent thin film layer (160).

The substrate (110) may include glass or an optical transparent film including, for example, various plastic materials having transparency such as PET (polyethylene terephthalate), PEN (polyethylene naphthalate), PC (polycarbonate), and acryl.

The first transparent thin film layer (120) is formed on one surface of the substrate (110). The first transparent thin film layer (120) may be formed by depositing a hydrophobic transparent thin film on one surface of the substrate (110) using deposition, coating, and printing methods. The first transparent thin film layer (120) is a configuration to prevent quantum dot particles forming the quantum dot layer (140) from being mixed or unevenly dispersed by surface tension. That is, the first transparent thin film layer (120) can obtain uniformity of quantum dot particles dispersed on the quantum dot layer (140).

The barrier member (130) is formed at an upper surface of the first transparent thin film layer (120) to form an area on which the quantum dot layer (140) and the protective layer (150) are stacked. The barrier member (130) may be formed on a surface of the first transparent thin film layer (120) by patterning technique including photo-lithographing, or by bonding a shape-processed film on a surface of the first transparent thin film layer (120). The barrier member (130) may further include a plurality of columns or grid-shaped lugs (131), each formed at a predetermined gap by passing through the quantum dot layer (140) and the protective layer (150).

Each of the barrier member (130), the columns or the lugs (131) is formed to have a same thickness and height as that of the stacked quantum dot layer (140) and the protective layer (150). The configuration of the barrier member (130) and columns or lugs contained therein can improve uniformity of quantum dot particles dispersed on the quantum dot layer (140). That is, the configuration of the barrier member (130) and columns or lugs contained therein can be conducive to self-alignment function in the course of the quantum dot layer (140) and the protective layer (150) being stacked, and to maintaining a surface gap during bondage of the second transparent thin film layer (160) formed at an extreme upper layer of the optical device (100), whereby the configuration performs a mechanical function that improves the uniformity.

The quantum dot layer (140) includes quantum dot particles and formed at an upper surface of the first transparent thin film layer (120). The quantum dot layer (140) includes quantum dot particles of solid state formed by drying solution in which quantum dot particles are dispersed. The band gap may be adjusted by adjusting the sizes of the quantum dot particles to obtain light of various wavelength bands from the quantum dot layer (140).

The quantum dot layer (140) may be configured to emit a single color by allowing the quantum dot particles, each having a same size, to be dispersed, or to allow quantum dot particles (each having a different size), each having a different band gap, to be dispersedly mixed at a predetermined ratio. Furthermore, a first quantum dot layer dispersed with quantum dot particles having a first band gap, a second quantum dot layer dispersed with quantum dot particles having a second band gap, and a nth quantum dot layer dispersed with quantum dot particles having a nth band gap may be stacked to form the quantum dot layer (140).

FIG.2b exemplifies a quantum dot layer (140) formed by dispersedly mixing first quantum dot particles (141) emitting light by wavelength-converting excited blue light to red light, and second quantum dot particles (143) emitting light by wavelength-converting excited blue light to green light at a predetermined ratio. In a case the blue light is excited on the thus-configured quantum dot layer (140), the quantum dot layer (140) can emit white light of high purity having a narrow FWHM by adjusting the mixing ratio of quantum dot particles, each having a different size.

The quantum dot particles forming the quantum dot layer (140) may be formed by nano crystal grain of core-shell such as CdSe/ZnS, or may be formed by any one of a group selected from a group consisting of II-VI compound semiconductor nanocrystal grain, a group III-V compound semiconductor nanocrystal grain, a group IV-VI compound semiconductor nanocrystal and the like. The preceding examples of the quantum dot layer may be used individually or combined with two or more crystal grains in the present embodiment.

More specifically, the group II-VI compound semiconductor nanocrystal may be selected from a group consisting of CdSe, CdTe, ZnS, ZnSe, ZnTe, ZnO, HgS, HgSe, HgTe, and a binary compound selected from a group formed by mixtures thereof, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HggZnTe, and a ternary compound selected from a group formed by mixtures thereof, and CdZnSeS, CdZnSeTe, CdZnSTe, CdHgSeS, CdHgSeTe, CdHgSTe, HgZnSeS, HgZnSeTe, HgZnSTe, and a quaternary compound selected from a group formed by mixtures thereof.

The group III-V compound semiconductor nanocrystal may be selected from a group consisting of GaN, GaP, GaAs, GaSb, AlN, AlP, AlAs, AlSb, InN, InP, InAs, InSb and a binary compound selected from a group formed by mixtures thereof, GaNP, GaNAs, GaNSb, GaPAs, GaPSb, AlNP, AINAs, AINSb, AlPAs, ALpsb, InNP, InNAs,InNSb, InPAs, InPSb, GaAlNP, and a ternary compound selected from a group formed by mixtures thereof, and GaAlNAs, GaAlNSb, GaAlPAs, GaAlPSb, GaInNP, GaInNSb, GaInPAs, GaInPSb, InAlNP, InAlNAs, InAlNSb, InAlPAs, InAlPSb, and a quaternary compound selected from a group formed by mixtures thereof.

The group IV-VI compound semiconductor nanocrystal may be may be selected from a group consisting of SnS, SnSe, SnTe, PbS, PbSe, PbTe, and a binary compound selected from a group formed by mixtures thereof,SnSeS, SnSeTe, SnSTe, PbSeS, PbSeTe, PbSTe, SnPbS, SnPbSe, SnPbTe, and a ternary compound selected from a group formed by mixtures thereof, and SnPbSSe, SnPbSeTe, SnPbSTe, and a quaternary compound selected from a group formed by mixtures thereof.

The protective layer (150) is formed on both the upper surface and the bottom surface (not shown) of the quantum dot layer (140), and includes inorganic material -based transparent nano particles (151). The transparent nano particles include metallic oxide nano particles each having a several nano meters.

The metallic oxide nano particles may be formed by mixing any one or a mixuture of more than two metallic oxides of ZnO, TiO₂, Al₂O₃, Ta₂O₅, MgO, NiO, Cr₂O₃, WO₃(tungsten trioxide) and VOₓ(vanadium oxide), or by sequentially stacking one or more metallic oxide nano particle substances.

The semiconductor nano particles, which are materials forming the quantum dot layer (140), are generally degradated in performance by outdoor air containing moisture and oxygen, and ultraviolet irradiated from outside. The protective layer (150) prevents the quantum dot particles from being degradated to enhance reliability and durability of the optical device (100) and to provide a stable expression of optical conversion efficiency. Although FIGS.2a and 2b exemplify the protective layer (150) stacked at an upper surface of the quantum dot layer (140), which configuration does not fall under the claimed invention, it should be apparent to the skilled in the art that the protective layer (150) can be stacked at a bottom surface of the quantum dot layer (140), which configuration also does not fall under the claimed invention, and stacked on both the upper and bottom surfaces of the quantum dot layer (140), which configuration falls under the claimed invention.

The second transparent thin film layer (160) is formed at an extreme upper layer of the optical device (100) to protect the quantum dot layer (140) and the protective layer (150) against an external environment. The second transparent thin film layer (160) may be formed with any one material from organic material or inorganic material, or may be stacked with or bonded by the organic material and inorganic material. For example, the second transparent thin film layer (160) may include resin. The second transparent thin film layer (160) that may be selectively formed on the extreme upper surface of the first transparent thin film layer (120) and the optical device (100) formed on the substrate (110) enhances an airtight-seal characteristic of the quantum dot layer (140) and the protective layer (150) formed therebetween.

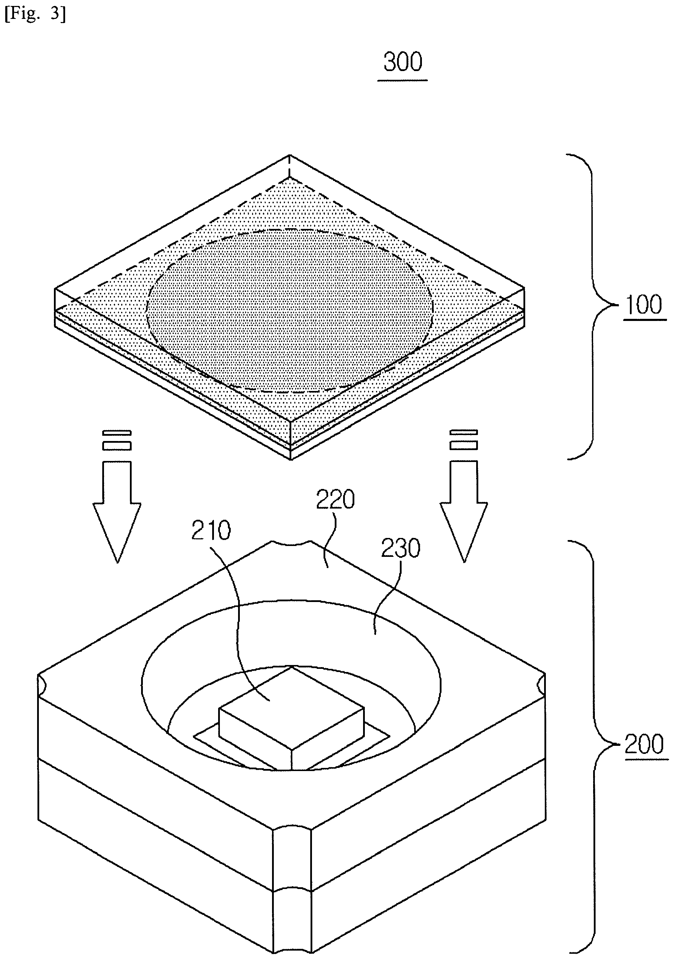

FIG.3 is a schematic perspective view illustrating an LED package according to the present invention. A LED package (300) according to the present invention is realized by bonding the optical device (100) of FIG. 1a to an LED chip, and no more redundant explanation on the optical device (100) as that of FIG. 1a will be provided except for the following separate one.

A LED chip (200) includes a housing that further includes an LED (Light Emitting Diode, 210) emitting a first light, a bottom surface part mounted with the LED (210), a lateral wall part (230) protruded upwards from the bottom surface part to encompass the LED (210), and an optical emission part (220) formed on an opened upper surface of the lateral wall part (230).

The lateral wall part (230) may include a reflective surface, where the reflective surface reflects the first light generated by the LED (210) and can emit the first light more efficiently to outside through the optical emission part (220).

The LED package (300) according to the present invention is formed by the optical device (100) being bonded to the optical emission part (220) of the LED chip (200). FIG.3 exemplifies that the optical emission part (220) is bonded to the second transparent thin film layer (160) of the optical device (100) to allow the substrate (110) to become an upper surface of the LED package (300). Alternatively, the substrate (110) of the optical device (100) may be bonded to the optical emission part (220) to allow the upper surface of the LED package (300) to become the second transparent thin film layer (160).

An inner space encompassed by the lateral wall part (230) of the housing, that is, a space formed by the LED (210) and the optical device (100), may be left vacant, or filled with a transparent refractivity matching material for enhancing an optical extraction efficiency of the LED (210).

The LED package (300) according to the present invention may be formed by the optical device (100) being bonded to the LED chip (200) including, for example, a blue LED. As illustrated in FIG.2b, the quantum dot layer of the optical device (100) may be formed by mixing first quantum dot particles emitting red light by wavelength-converting blue excited light with second quantum dot particles emitting green light by wavelength-converting blue excited light at a predetermined ratio. As a result, a part of the blue light emitted from the blue LED is converted to green light or red light. That is, in a case the LED chip (200) including the blue LED is bonded to the optical device (100) including the quantum dot layer, blue, red and green colors are mixed to resultantly emit white color. Thus, the LED package (300) may be used as a white light source device for liquid crystal display device, and/or an illumination device of various colors by adjusting the mixing ratio of the quantum dot particles.

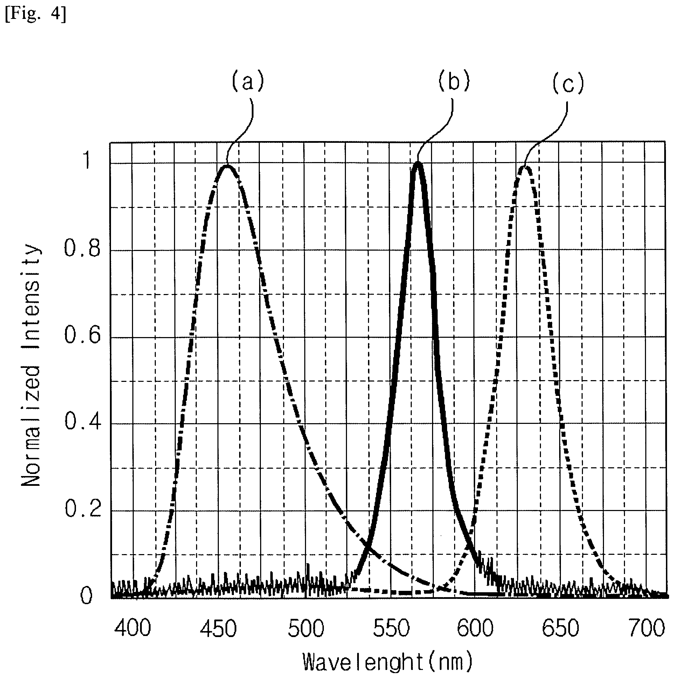

FIG.4 is a schematic view illustrating a light emitting spectrum of an LED package according to an exemplary embodiment of the present invention.

FIG.4 illustrating a light emitting spectrum of an LED package formed by bonding an optical device according to an exemplary embodiment of the present invention to a blue LED chip. The light emitting spectrum is a light emitting spectrum of an LED chip in which the optical device (100) including the quantum dot layer (140) illustrated in FIG.2b is bonded to the blue LED chip. That is, the light emitting spectrum is formed by normalizing a light spectrum of red wavelength band formed by first quantum dot particles (141) emitting light by wavelength-converting the blue excited light emitted from the blue light LED to red light and a light spectrum of green wavelength band formed by second quantum dot particles (143) emitting light by wavelength-converting the blue excited light to green light.

Referring to FIG.4, (a) illustrates a spectrum of blue light emitted from a blue LED, (b) illustrates a spectrum of green light emitted by being wavelength-converted in the quantum dot layer (140), and (c) illustrates a spectrum of red light emitted by being wavelength-converted in the quantum dot layer (140). Referring to FIG.4 again, it can be noted that light spectrums of each blue, green and red primary color wavelength band has a narrow FWHM and purity is very high. In a case the white color light source with high color purity is used for a backlight, a color gamut is broadened to enable color expression near to natural color, and in a case the white color light source with high color purity is applied for general illumination, a CRI expressing resemblance to the natural light can be realized to a conventional LED illumination level, and color temperature can be easily adjusted.

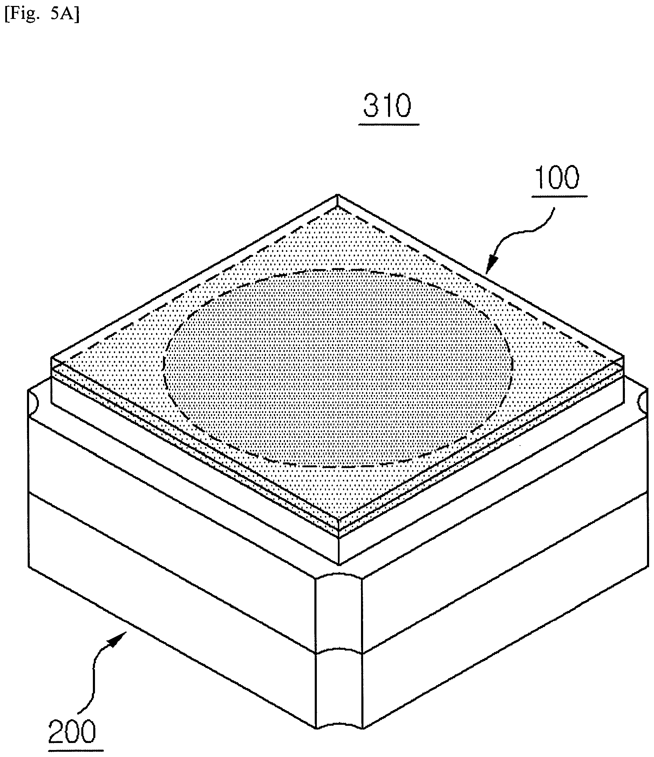

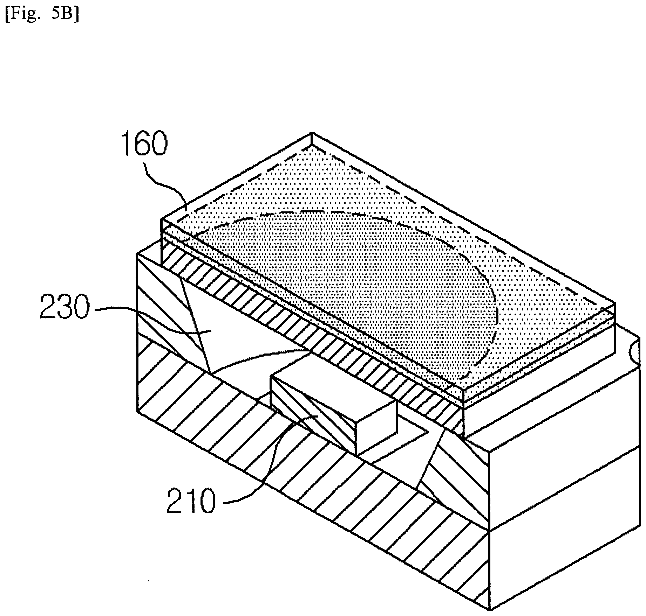

FIGS.5a and 5b are perspective and cross-sectional views illustrating an LED package according to another exemplary embodiment of the present invention.

Referring to FIGS.5a and 5b, an LED package (310) includes an LED chip (200) and an optical device (100). FIGS.5a and 5b illustrate the LED package (310), in which a substrate of the optical device (100) is bonded to an optical emission part of the LED chip (200). That is, in comparison with the LED package (300) of FIG.3, a portion of the optical device (100) bonded to the optical emission part of the LED chip (200) is a bit different, where an upper surface of the LED package (310) becomes the second transparent thin film layer (160) of the optical device (100).

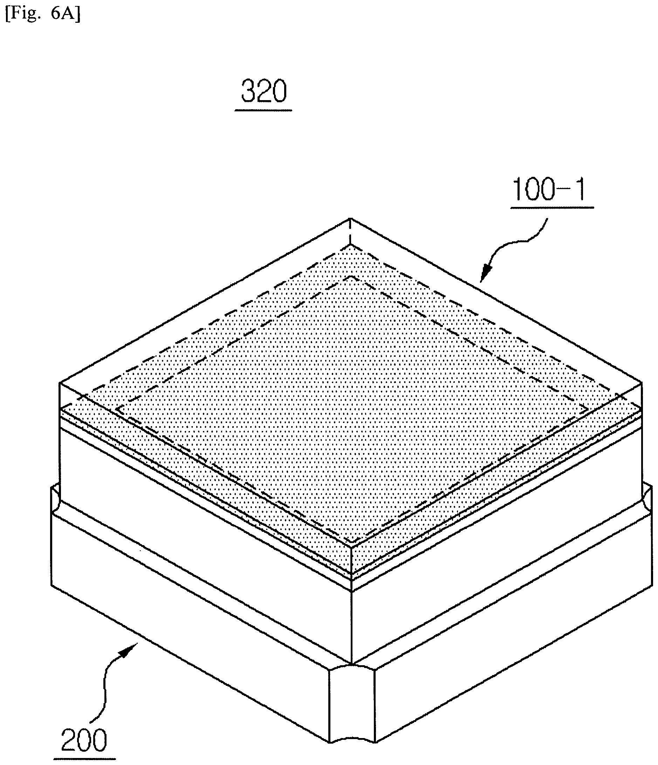

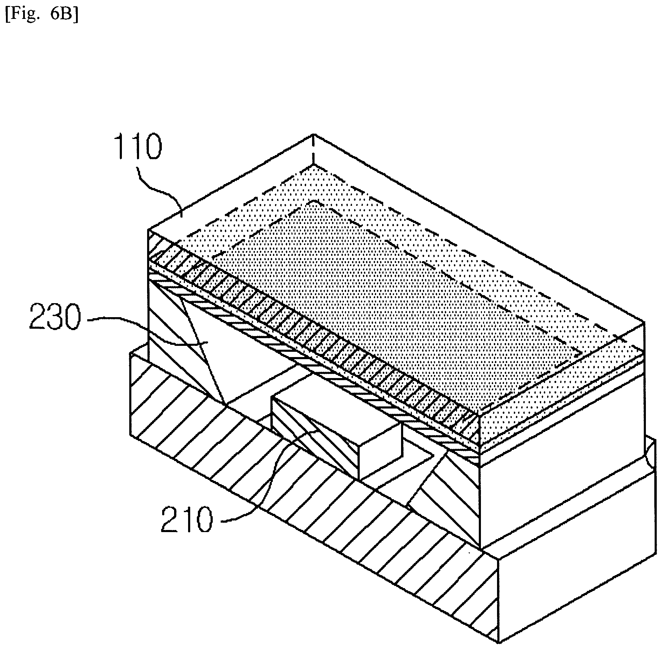

FIGS.6a and 6b are perspective and cross-sectional views illustrating an LED package according to still another exemplary embodiment of the present invention.

Referring to FIGS.6a and 6b, an LED package (320) includes an LED chip (200) and an optical device (100-1). The optical device (100-1) is formed in a square shape at a light emitting area set by a barrier member. FIGS.6a and 6b illustrate the LED package (320) formed by bonding the second transparent thin film layer to an optical emission part of the LED chip (200). That is, an upper surface of the LED package (320) becomes a substrate (110) of the optical device (100-1).

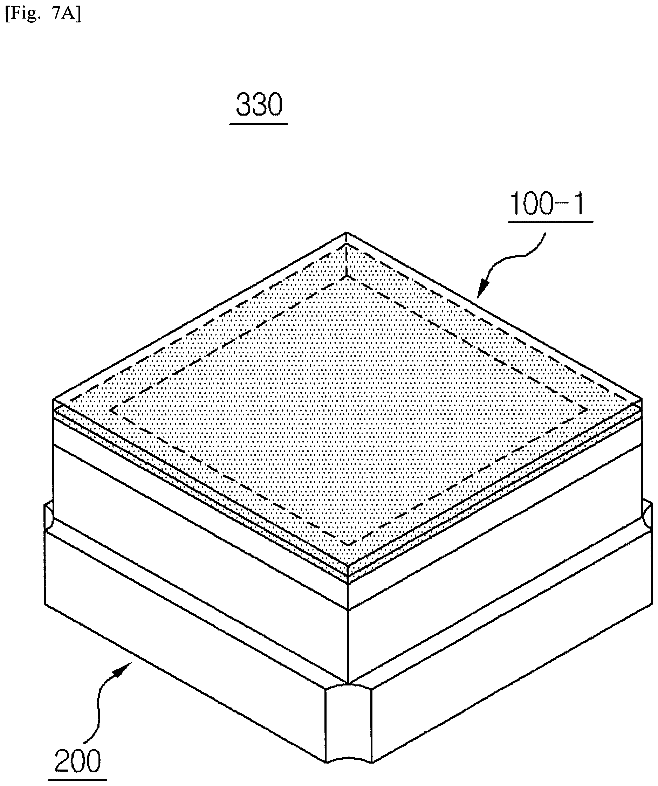

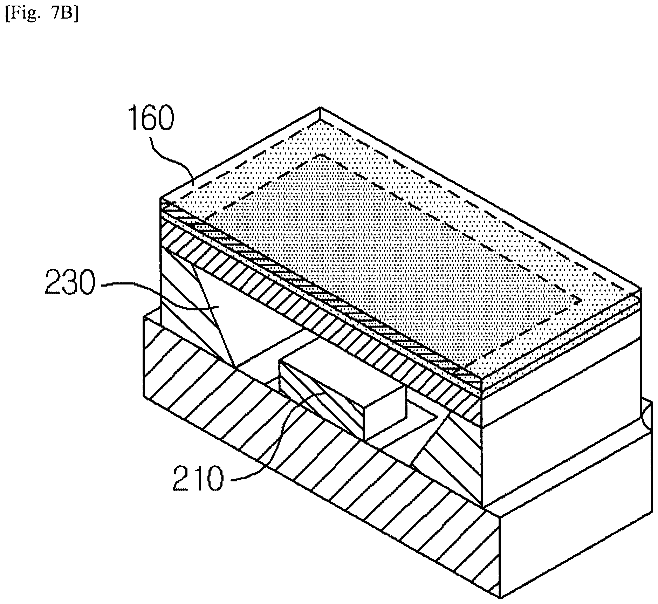

FIGS.7a and 7b are perspective and cross-sectional views illustrating an LED package according to still another exemplary embodiment of the present invention.

Referring to FIGS. 7a and 7b, an LED package (330) includes an LED chip (200) and an optical device (100-1). The optical device (100-1) is formed in a square shape at a light emitting area set by a barrier member. FIGS.7a and 7b illustrate the LED package (330) formed by bonding a substrate of the optical device (100-1) to an optical emission part of the LED chip (200). That is, an upper surface of the LED package (330) becomes the second transparent thin film layer (160) of the optical device (100-1).

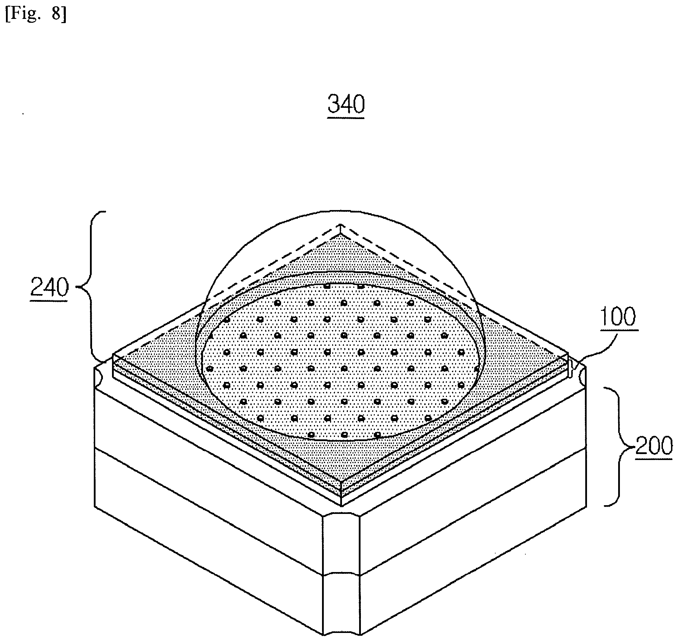

FIG.8 is a perspective view illustrating an LED package according to still another exemplary embodiment of the present invention.

Referring to FIG. 8, an LED package (340) includes an optical device (100), an LED chip (200) and a luminosity adjusting part (240). The luminosity adjusting part (240) is a configuration for optimizing an optical emission efficiency and luminosity dispersion. The luminosity adjusting part (240) may be formed by integrating a dome-shaped lens, a fine lens arrangement or a convexly/concavely shaped layer, or a lens provided in the form of a part.

The previous description of the present invention is provided to enable any person skilled in the art to make or use the invention. Various modifications to the embodiments of the invention will be readily apparent to those skilled in the art, and the generic principles defined herein may be applied to other variations without departing from the scope of the invention. Thus, the invention is not intended to be limited by the examples described herein, but is to be accorded the widest scope consistent with the principles and novel features disclosed herein. The scope of the present invention is defined by the appended claims.

### Industrial Applicability

As apparent from the foregoing, the optical device and LED package using the same, and a backlight apparatus according to the present invention have an industrial applicability in that both surfaces of the quantum dot layer consisting of quantum dot particles are deposited or coated with a protective layer formed with metallic oxide nano particles, and that the second transparent thin film layer is formed in such a way that the quantum dot layer and the protective layer are airtightly sealed, to enhance reliability and durability of the quantum dot particles and to prevent degradation in performance caused by moisture, oxygen and ultraviolet.

## Claims

1. An optical device (100; 100-1), comprising:
a substrate (110);
a first transparent thin film layer (120) formed at one surface of the substrate (110);
a quantum dot layer (140) formed at an upper surface of the first transparent thin film layer (120) and consisting of quantum dot particles;
a protective layer (150) formed on both the upper surface and the bottom surface of the quantum dot layer (140);
a barrier member (130; 130-1) formed on the upper surface of the first transparent thin film layer (120) for establishing an area formed with the quantum dot layer (140) and the protective layer (150); and a second transparent thin film layer (160) formed at an extreme upper layer of the optical device (100; 100-1),
**characterized in that**:
the protective layer (150) is formed with metallic oxide nano particles; and
the second transparent thin film layer (160) is formed in such a way that the quantum dot layer (140) and the protective layer (150) are airtightly sealed.

2. The optical device (100; 100-1) of claim 1, wherein the quantum dot layer (140) is diffusively mixed with the quantum dot particles at a predetermined ratio, each quantum dot particle having a different band gap.

3. The optical device (100; 100-1) of claim 2, wherein the quantum dot particles include a first quantum dot particle (141) wavelength-converting blue light to red light, and a second quantum dot particle (143) wavelength-converting blue light to green light.

4. The optical device (100; 100-1) of claim 1, wherein the metallic oxide nano particles include at least one of ZnO, TiO₂, Al₂O₃, Ta₂O₅, MgO, NiO, Cr₂O₃, WO₃ and VOx.

5. The optical device (100; 100-1) of claim 1, wherein the barrier member (130; 130-1) further includes a plurality of columns or grid-shaped lugs (131), each formed at a predetermined gap by passing through the quantum dot layer (140) and the protective layer (150).

6. A light emitting diode (LED) package (300; 310; 320; 330; 340), comprising:
the optical device (100; 100-1) according to any one of claims 1 to 5;
and an LED chip (200), comprising:
a housing including:
an LED (210);
a bottom surface part mounted with the LED (210);
a lateral wall part (230) protruded to an upper direction from the bottom surface part to encompass the LED (210); and an optical emission part (220) formed on an opened upper surface of the lateral wall part (230),
wherein the optical device (100; 100-1) is bonded to the optical emission part (220) and includes quantum dot particles emitting light by wavelength converting a part of the light emitted by the LED (210).

7. The LED package (300; 310; 320; 330; 340) of claim 6, wherein the housing further comprises a reflective surface formed at an inner surface of the lateral wall part (230).

8. The LED package (300; 310; 320; 330; 340) of claim 6, wherein an inner space encompassed by the lateral wall part (230) is filled with a transparent refractivity matching material for enhancing an optical extraction efficiency of the LED (210).

9. The LED package (340) of claim 6, further comprising a luminosity adjusting part (240) formed on an upper surface of the optical device (100).

10. The LED package (340) of claim 9, wherein the luminosity adjusting part (240) is any one of a dome-shaped lens, a fine lens arrangement or a convexly/concavely shaped layer.

11. A backlight apparatus applied with the LED package (300; 310; 320; 330; 340) of claim 6.

## Patentansprüche

1. Optische Vorrichtung (100; 100-1), die Folgendes umfasst:
ein Substrat (110);
eine erste transparente Dünnschicht (120), die auf einer Oberfläche des Substrats (110) gebildet ist;
eine Quantenpunktschicht (140), die auf einer oberen Oberfläche der ersten transparenten Dünnschicht (120) gebildet ist und aus Quantenpunktpartikeln besteht;
eine Schutzschicht (150), die sowohl auf der oberen Oberfläche als auch auf der unteren Oberfläche der Quantenpunktschicht (140) gebildet ist;
ein Sperrelement (130; 130-1), das auf der oberen Oberfläche der ersten Dünnschicht (120) gebildet ist, um einen Bereich einzurichten, der aus der Quantenpunktschicht (140) und der Schutzschicht (150) gebildet ist; und
eine zweite transparente Dünnschicht (160), die auf einer äußersten oberen Schicht der optischen Vorrichtung (100; 100-1) gebildet ist;
**dadurch gekennzeichnet, dass**:
die Schutzschicht (150) aus Metalloxid-Nanopartikeln gebildet ist und
die zweite transparente Dünnschicht (160) derart gebildet ist, dass die Quantenpunktschicht (140) und die Schutzschicht (150) luftdicht abgedichtet sind.

2. Optische Vorrichtung (100; 100-1) nach Anspruch 1, wobei die Quantenpunktschicht (140) mit den Quantenpunktpartikeln in einem vorbestimmten Verhältnis diffusiv vermischt ist, wobei jedes Quantenpunktpartikel eine andere Bandlücke aufweist.

3. Optische Vorrichtung (100; 100-1) nach Anspruch 2, wobei die Quantenpunktpartikel ein erstes Quantenpunktpartikel (141), das blaues Licht in rotes Licht wellenlängenkonvertiert, und ein zweites Quantenpunktpartikel (143), das blaues Licht in grünes Licht wellenlängenkonvertiert, enthalten.

4. Optische Vorrichtung (100; 100-1) nach Anspruch 1, wobei die Metalloxid-Nanopartikel ZnO, TiO₂, Al₂O₃, Ta₂O₅, MgO, NiO, Cr₂O₃, WO₃ und/oder VOx enthalten.

5. Optische Vorrichtung (100; 100-1) nach Anspruch 1, wobei das Sperrelement (130; 130-1) ferner mehrere Säulen oder gitterförmige Vorsprünge (131) enthält, die jeweils an einer vorbestimmten Lücke gebildet sind, indem sie die Quantenpunktschicht (140) und die Schutzschicht (150) durchquert.

6. Leuchtdiodenbaugruppe (LED-Baugruppe) (300; 310; 320; 330; 340), die Folgendes umfasst:
die optische Vorrichtung (100; 100-1) nach einem der Ansprüche 1 bis 5; und
einen LED-Chip (200), der Folgendes umfasst:
ein Gehäuse, das Folgendes enthält:
eine LED (210);
ein Abschnitt einer unteren Oberfläche, an dem die LED (210) montiert ist;
einen Seitenwandabschnitt (230), der von dem Abschnitt der unteren Oberfläche in einer Aufwärtsrichtung vorsteht, um die LED (210) zu umgeben; und
ein Lichtemissionsteil (220), das auf einer offenen oberen Oberfläche des Seitenwandabschnitts (230) gebildet ist,
wobei die optische Vorrichtung (100; 100-1) mit dem Lichtemissionsteil (220) verbunden ist und Quantenpunktpartikel enthält, die durch Wellenlängenkonversion eines Teils des von der LED (210) emittierten Lichts Licht emittieren.

7. LED-Baugruppe (300; 310; 320; 330; 340) nach Anspruch 6, wobei das Gehäuse ferner eine reflektierende Oberfläche umfasst, die auf einer inneren Oberfläche des Seitenwandabschnitts (230) gebildet ist.

8. LED-Baugruppe (300; 310; 320; 330; 340) nach Anspruch 6, wobei ein Innenraum, der von dem Seitenwandabschnitt (230) umgeben ist, mit einem transparenten, im Brechungsindex übereinstimmenden Material gefüllt ist, um eine optische Extraktionseffizienz der LED (210) zu erhöhen.

9. LED-Baugruppe (340) nach Anspruch 6, die ferner einen Leuchtkrafteinstellabschnitt (240) umfasst, der auf einer oberen Oberfläche der optischen Vorrichtung (100) gebildet ist.

10. LED-Baugruppe (340) nach Anspruch 9, wobei der Leuchtkrafteinstellabschnitt (240) eine kuppelförmige Linse, eine Feinlinsenanordnung oder eine konvex bzw. konkav geformte Schicht ist.

11. Hintergrundbeleuchtungsvorrichtung, auf die die LED-Baugruppe (300; 310; 320; 330; 340) nach Anspruch 6 angewendet wird.

## Revendications

1. Dispositif optique (100 ; 100-1) comportant :
un substrat (110) ;
une première couche de film mince transparente (120) formée sur une surface du substrat (110) ;
une couche de points quantiques (140) formée sur une surface supérieure de la première couche de film mince transparente (120) et constituée de particules de points quantiques ;
une couche protectrice (150) formée à la fois sur la surface supérieure et la surface inférieure de la couche de points quantiques (140) ;
un élément barrière (130; 130-1) formé sur la surface supérieure de la première couche de film mince transparente (120) pour établir une zone formée avec la couche de points quantiques (140) et la couche protectrice (150) ; et une seconde couche de film mince transparente (160) formée sur une couche supérieure extrême du dispositif optique (100; 100-1),
**caractérisé en ce que** :
la couche protectrice (150) est formée avec des nanoparticules d'oxyde métallique ; et la seconde couche de film mince transparente (160) est formée de telle manière que la couche de points quantiques (140) et la couche protectrice (150) sont scellées de manière étanche à l'air.

2. Dispositif optique (100; 100-1) selon la revendication 1, dans lequel la couche de points quantiques (140) est mélangée de manière diffusive avec les particules de points quantiques à un rapport prédéterminé, chaque particule de point quantique ayant une largeur de bande interdite différente.

3. Dispositif optique (100; 100-1) selon la revendication 2, dans lequel les particules de points quantiques incluent une première particule de point quantique (141) convertissant en longueur d'onde une lumière bleue en lumière rouge, et une seconde particule de point quantique (143) convertissant en longueur d'onde une lumière bleue en lumière verte.

4. Dispositif optique (100 ; 100-1) selon la revendication 1, dans lequel les nanoparticules d'oxyde métallique incluent au moins un élément parmi ZnO, TiO₂, Al₂O₃, Ta₂O₅, MgO, NiO, Cr₂O₃, WO₃ et VOx.

5. Dispositif optique (100 ; 100-1) selon la revendication 1, dans lequel l'élément barrière (130; 130-1) inclut en outre une pluralité de colonnes ou de pattes en forme de grille (131), formées chacune à un intervalle prédéterminé en passant à travers la couche de points quantiques (140) et la couche protectrice (150).

6. Boîtier de diode électroluminescente (LED) (300; 310 ; 320; 330; 340) comportant :
le dispositif optique (100; 100-1) selon l'une quelconque des revendications 1 à 5 ;
et une puce à LED (200), comportant :
un boîtier incluant :
une LED (210) ;
une partie de surface inférieure montée avec la LED (210) ;
une partie de paroi latérale (230) faisant saillie jusqu'à une direction supérieure à partir de la partie de surface inférieure pour envelopper la LED (210) ; et une partie d'émission optique (220) formée sur une surface supérieure ouverte de la partie de paroi latérale (230),
dans lequel le dispositif optique (100; 100-1) est assemblé à la partie d'émission optique (220) et inclut des particules de points quantiques émettant de la lumière en convertissant en longueur d'onde une partie de la lumière émise par la LED (210).

7. Boîtier de LED (300; 310; 320; 330; 340) selon la revendication 6, dans lequel le boîtier comporte en outre une surface réfléchissante formée sur une surface intérieure de la partie de paroi latérale (230).

8. Boîtier de LED (300; 310; 320; 330; 340) selon la revendication 6, dans lequel un espace intérieur enveloppé par la partie de paroi latérale (230) est rempli d'un matériau d'adaptation de réflectivité transparent pour améliorer un rendement d'extraction optique de la LED (210).

9. Boîtier de LED (340) selon la revendication 6, comportant en outre une partie de réglage de luminosité (240) formée sur une surface supérieure du dispositif optique (100).

10. Boîtier de LED (340) selon la revendication 9, dans lequel la partie de réglage de luminosité (240) est un élément quelconque parmi une lentille en forme de dôme, un agencement de lentille fine ou une couche formée de manière convexe/concave.

11. Appareil de rétroéclairage appliqué au boîtier de LED (300 ; 310; 320; 330; 340) selon la revendication 6.
